# EUROPEAN PATENT APPLICATION

(11) **EP 4 704 138 A1**
(43) Date of publication of application: **04.03.2026**
(21) Application number: 24197820.4
(22) Date of filing: 02.09.2024
(51) Int. Cl.: H01J 37/32, H03H 7/38, H03H 7/40

(54) **IMPEDANCE MATCHING NETWORK FOR PLASMA PROCESSES, PLASMA CONTROL SYSTEM AND METHOD OF IMPEDANCE MATCHING FOR A PLASMA PROCESS**

(71) Applicant: Rohde & Schwarz GmbH & Co. KG, 81671 München (DE)
(72) Inventor: Pietzka, Mathias, 81671 München (DE); Ohnimus, Florian, 81671 München (DE)
(74) Representative: Prinz & Partner mbB

(57) **Abstract**

An impedance matching network (20) for plasma processes is described. The impedance matching network (20) comprises an input port (28) and an output port (30). The impedance matching network (20) further comprises a transmission line (32), wherein the transmission line (32) connects the output port (30) to the input port (28). The impedance matching network (20) comprises a first impedance matching module (34), wherein the first impedance matching module (34) is configured to connect at least one reactance to the transmission line (32). The first impedance matching module (34) comprises a first reactance set and a second reactance set. The first reactance set of the first impedance matching module (34) comprises least one adjustable reactance, wherein an impedance of the at least one adjustable reactance is adaptable. The second reactance set of the first impedance matching module (34) comprises least one non-adjustable reactance, wherein an impedance of the at least one non-adjustable reactance is fixed. The first reactance set and the second reactance set are arranged in parallel to each other. The first impedance matching module (34) is configured to switch reactances of the first reactance set and of the second reactance set to the transmission line (32) independent of each other. Further, a plasma control system and a method of impedance matching for a plasma process are described.

## Description

The present invention generally relates to an impedance matching network for plasma processes. The present invention further relates to a plasma control system and to a method of impedance matching for a plasma process.

For igniting and maintaining a plasma, usually an RF power generator is connected to a chamber feed unit that transfers the power of the RF signal generated by the RF power generator into a plasma chamber containing the plasma.

As the impedance of the plasma usually differs significantly from commonly used interface impedances (e.g. 50 Ohm), and as the impedance can vary significantly over time and power level, it is common in the state of the art to provide an impedance matching network in order to optimize the efficiency of the power transfer into the plasma.

In fact, before the plasma is initiated, the load impedance presented to the RF power generator is extremely high, while the impedance of a stable plasma after initiation is low. The change from the high-impedance state to the low-impedance state of the plasma happens rather fast during ignition of the plasma, requiring a fast adaptation of the impedance of the impedance matching network.

The object of the present invention is to provide an impedance matching network, a plasma control system, and a method of impedance matching for a plasma process that enable a fast and accurate tuning of the impedance.

According to the present invention, the problem is solved by an impedance matching network for plasma processes. The impedance matching network comprises an input port being connectable to a radio frequency, RF, generator module. The impedance matching network further comprises an output port being connectable to a load. The impedance matching network further comprises a transmission line, wherein the transmission line connects the output port to the input port. The impedance matching network comprises a first impedance matching module, wherein the first impedance matching module is configured to connect at least one reactance to and/or into the transmission line. The first impedance matching module comprises a first reactance set and a second reactance set. The first reactance set of the first impedance matching module comprises least one adjustable reactance, wherein an impedance of the at least one adjustable reactance is adaptable. The second reactance set of the first impedance matching module comprises least one non-adjustable reactance, wherein an impedance of the at least one non-adjustable reactance is fixed. The first reactance set and the second reactance set are arranged in parallel to each other. The first impedance matching module is configured to switch reactances of the first reactance set and of the second reactance set to and/or into the transmission line independent of each other.

Therein and in the following, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry, and/or electronic components such as resistors, capacitors, and/or inductors.

The impedance matching network according to the present disclosure is based on the idea to combine at least two different types of impedance matching.

The first reactance set of the first impedance matching module has at least one adjustable reactance with an adaptable impedance, i.e. the impedance of the at least one adjustable reactance can be tuned within a predetermined impedance range, such that the impedance of the impedance matching network is adapted.

In fact, by adapting the impedance of the at least one adjustable reactance, a coarse tuning of the impedance matching network may be performed.

The second reactance set comprises at least one non-adjustable reactance having fixed impedance. The at least one non-adjustable reactance can be selectively switched to and/or into the transmission line or be disconnected from the transmission line. This allows to adapt the impedance of the impedance matching network in a particularly fast manner, as the achievable switching times of a corresponding electronic switch assigned to the at least one non-adjustable reactance are fast.

For example, the electronic switch(es) may be established as a solid-state switch. In fact, the electronic switch(es) may be or comprise a mechanical switch, a micro-electromechanical systems (MEMS) switch, a semiconductor switch, a PIN diode, a MOSFET, or other suitable type of electronic circuitry.

The combination of the first reactance set and of the second reactance set allows to adapt the impedance of the impedance matching network over a broad range that covers all operational states of the plasma, i.e. before and after ignition of the plasma, as the first impedance matching module is configured to switch reactances of the first reactance set and of the second reactance set to and/or into the transmission line independent of each other.

Moreover, due to the achievable fast switching times of the electronic switches, particularly fast tuning times are provided by the impedance matching network according to the present invention.

In fact, the switching times of the electronic switches may be as low as of the order of microseconds or even below.

Accordingly, tuning times of the order of microseconds may be achievable.

The individual reactances may be established as a capacitor or as an inductor, respectively.

The first impedance matching module may be connected between the transmission line and a common reference potential. Accordingly, the reactances of the first reactance set and the second reactance set may be selectively connected between the transmission line and the common reference potential by the first impedance matching module.

For example, the common reference potential may be a ground potential.

Attentively, the first impedance matching module may be interconnected between the input port and the output port. Accordingly, the reactances of the first reactance set and of the second reactance set may be selectively connected into the transmission line between the input port and the output port.

The impedance matching network may further comprise at least one motor being connected to the at least one adjustable reactance, wherein the at least one motor is configured to adapt the impedance of the at least one adjustable reactance, particularly wherein the at least one adjustable reactance is a variable vacuum capacitor, VVC. Such motor-driven reactances allow to adjust their impedance continuously and over a wide impedance range. Accordingly, the impedance of the impedance matching network can be adapted continuously and over a wide impedance range.

For example, the at least one motor may be established as a stepper motor.

According to an aspect of the present invention, the second reactance set comprises a plurality of non-adjustable reactances, wherein the non-adjustable reactances are arranged in parallel and/or in series. By providing several reactances in series, the proof voltage of the first impedance matching module can be enhanced. Providing several reactances in parallel, wherein the several reactances can be individually and selectively connected to or into the first transmission line, allows to adjust the impedance of the second reactance set over a wider range, and thus allows to adjust the impedance of the impedance matching network over a wider range.

In an embodiment of the present invention, the first impedance matching module comprises a third reactance set, wherein the third reactance set comprises at least one adjustable reactance, wherein an impedance of the at least one adjustable reactance is adaptable by a bias voltage. Accordingly, a further possibility of adapting the impedance of the impedance matching network is provided, namely by appropriately controlling the at least one adjustable reactance of the third reactance set by providing a corresponding bias voltage. This way, the achievable impedance range covered by the impedance matching network is further enhanced. Moreover, this enables a continuous and fast adaptation of the impedance of the first impedance matching module and thus of the impedance matching network.

According to another aspect of the present invention, the third reactance set comprises a plurality of adjustable reactances, wherein the adjustable reactances are arranged in parallel and/or in series. By providing several reactances in series, the proof voltage of the first impedance matching module can be enhanced. Providing several reactances in parallel allows to adjust the impedance of the third reactance set over a wider range, and thus allows to adjust the impedance of the impedance matching network over a wider range.

In a further embodiment of the present invention, the impedance matching network comprises a voltage control module, wherein the voltage control module is connected to the at least one adjustable reactance of the third reactance set, and wherein the voltage control module is configured to control a bias voltage applied to the at least one adjustable reactance of the third reactance set, particularly wherein the bias voltage applied is a direct current, DC, voltage. In other words, the voltage control module is configured to set an impedance of the third reactance set by controlling the bias voltage applied to the at least one adjustable reactance of the third reactance set.

An aspect of the present disclosure provides that the voltage control module is configured to control the bias voltage applied to different adjustable reactances of the third reactance set group-wise or individually. Accordingly, the impedances of the different adjustable reactances can be adapted group-wise or for the different adjustable reactances individually.

For example, the bias voltage applied to the different adjustable reactances may be the same for all of the adjustable reactances of the third reactance set.

As another example, different bias voltages may be applied to different groups of adjustable reactances of the third reactance set.

In a further example, different bias voltages may be applied to each of the different adjustable reactances of the third reactance set.

The impedance matching network may comprise at least one bias tee that is connected to the at least one adjustable reactance of the third reactance set and to the voltage control module, such that the bias voltage is applied to the at least one adjustable reactance via the at least one bias tee.

In fact, one bias tee may be provided per adjustable reactance. In other words, each adjustable reactance of the third reactance set may be assigned a own bias tee. This allows to adjust the bias voltage applied to the different adjustable reactances for each of the different adjustable reactances.

In an embodiment of the present invention, the third reactance set is arranged in parallel to the first reactance set and to the second reactance set, wherein the first impedance matching module is configured to switch reactances of the first reactance set, of the second reactance set, and of the third reactance set to and/or into the transmission line independent of each other. The combination of the first reactance set, of the second reactance set, and of the third reactance set allows to adapt the impedance of the impedance matching network over an even broader range.

The impedance matching network may further comprise a second impedance matching module, wherein the first impedance matching module is connected between the transmission line and a common reference potential, and wherein the second impedance matching module is arranged in the transmission line between the input port and the output port. Accordingly, two separate impedance matching modules are provided, wherein the impedance of the first impedance matching module may be adaptable independent of the impedance of the second impedance matching module. Thus, the impedance of the impedance matching network can be adapted over an even broader range by means of the first impedance matching module and the second impedance matching module. Further, this allows to adapt the impedance of the impedance matching network in a particularly precise manner.

In a further embodiment of the present invention, the second impedance matching module comprises a first reactance set and a second reactance set, wherein the first reactance set of the second impedance matching module comprises least one adjustable reactance, wherein an impedance of the at least one adjustable reactance is adaptable, wherein the second reactance set of the second impedance matching module comprises least one non-adjustable reactance, wherein an impedance of the at least one non-adjustable reactance is fixed, wherein the first reactance set and the second reactance set are arranged in parallel to each other, and wherein the second impedance matching module is configured to switch reactances of the first reactance set and of the second reactance set to and/or into the transmission line independent of each other. Regarding the advantages and further properties of the impedance matching network comprising the second impedance matching module, reference is made to the explanations given above with respect to the first impedance matching module, which likewise apply to the second impedance matching module.

In fact, the second impedance matching module may be established analogously to any of the variants of the first impedance matching module described above.

According to the present invention, the problem further is solved by a plasma control system, wherein the plasma control system comprises at least one impedance matching network according to any one of the variants described above.

Regarding the advantages and further properties of the plasma control system, reference is made to the explanations given above with respect to the impedance matching network, which also hold for the plasma control system and vice versa.

An aspect of the present invention provides that the plasma control system further comprises at least one RF generator module, and at least one chamber feed unit, wherein the at least one chamber feed unit is configured to feed energy into plasma, wherein the input port of the at least one impedance matching network is connected to the at least one RF generator module, and wherein the output port of the at least one impedance matching network is connected to the at least one chamber feed unit. Accordingly, the impedance matching network may be configured to adapt the impedance of the load presented to the RF generator module, such that the energy fed into the plasma by the chamber feed unit is maximized, while reflection losses are minimized.

For example, the chamber feed unit may be established as an electrode and/or as an RF antenna.

In an embodiment of the present invention, the plasma control system further comprises a first measurement module, a second measurement module, and a control module, wherein the first measurement module is connected to the at least one RF generator module, wherein the first measurement module is configured to determine at least one first measurement parameter based on at least one RF signal generated by the at least one RF generator module, wherein the second measurement module is connected to the output port of the at least one impedance matching network, wherein the second measurement module is configured to determine at least one second measurement parameter based on at least one output signal of the at least one impedance matching network, and wherein the control module is configured to control the at least one impedance matching network based on the at least one first measurement parameter and based on the at least one second measurement parameter.

More precisely, the control module may be configured to control the first impedance matching module and/or the second impedance matching module described above to adapt their respective impedance.

In fact, the control module may determine an impedance of the impedance matching network based on the at least one first measurement parameter and based on the at least one second measurement parameter. The control module may compare the impedance determined with a target impedance that is to be set. The control module may control the impedance matching network to adapt its impedance based on the comparison.

The at least one first measurement parameter may comprise an amplitude of the input signal, a phase of the input signal, and/or a power level of the input signal. The amplitude and phase of the input signal may relate to a voltage of the input signal or to a current of the input signal.

The at least one second measurement parameter may comprise an amplitude of the output signal, a phase of the output signal, and/or a power level of the output signal. The amplitude and phase of the input signal may relate to a voltage of the output signal or to a current of the output signal.

According to the present invention, the problem further is solved by a method of impedance matching for a plasma process. The method comprises the steps of:
- generating, by at least one RF generator module, at least one RF signal;
- processing, by at least one impedance matching network, particularly by at least one impedance matching network according to any one of the variants described above, the at least one RF signal, thereby obtaining at least one output signal;
- feeding the at least one output signal to at least one chamber feed unit;
- determining, by a first measurement module, at least one first measurement parameter based on the at least one RF signal;
- determining, by a second measurement module, at least one second measurement parameter based on the at least one output signal; and
- controlling, by a control module, the at least one impedance matching network to adapt an impedance of the at least one impedance matching network based on the at least one first measurement parameter and based on the at least one second measurement parameter.

Regarding the advantages and further properties of the method of impedance matching for a plasma process, reference is made to the explanations given above with respect to the impedance matching network and the plasma control system, which also hold for the method and vice versa.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a plasma control system according to the present invention;
- Figure 2 schematically shows an exemplary embodiment of an impedance matching network of the plasma control system of Figure 1;
- Figure 3 schematically shows a further exemplary embodiment of an impedance matching network of the plasma control system of Figure 1;
- Figure 4 schematically shows a first impedance matching module of the impedance matching network of Figure 2 or 3;
- Figure 5 schematically shows an exemplary embodiment of a third reactance set of an impedance matching module in more detail;
- Figure 6 schematically shows a second impedance matching module of the impedance matching network of Figure 3; and
- Figure 7 shows a flow chart of a method of impedance matching for a plasma process according to the present invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

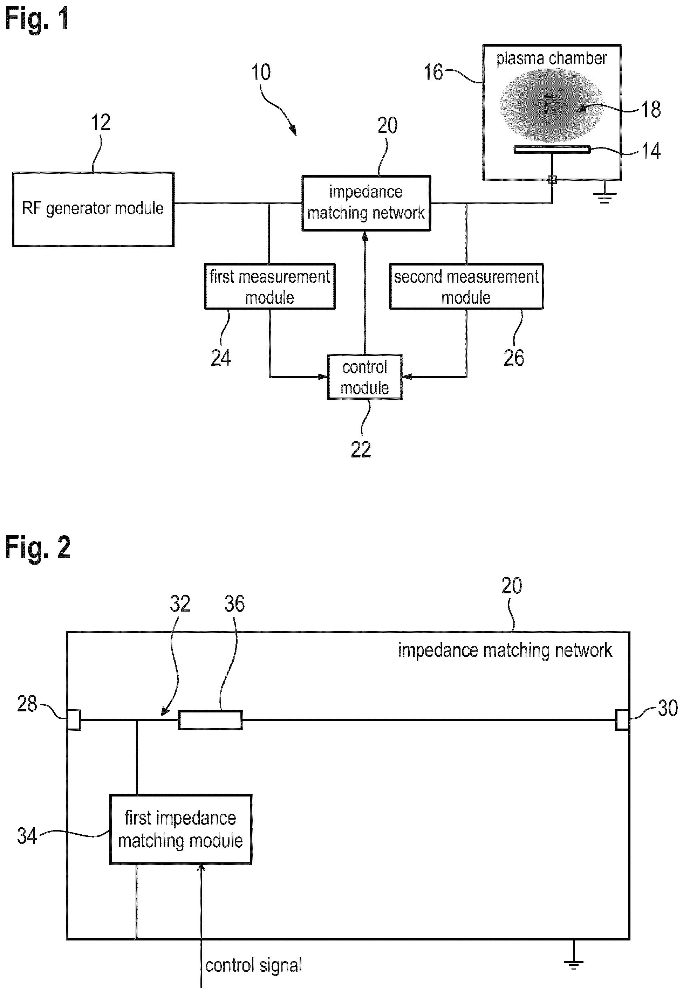

Figure 1 schematically shows a plasma control system 10 that comprises an RF generator module 12 and a chamber feed unit 14, wherein the chamber feed unit 14 is located in a plasma chamber 16.

In general, the RF generator module 12 is configured to generate an RF signal that is forwarded to the chamber feed unit 14.

The chamber feed unit 14 feeds the RF signal into plasma 18 contained in the plasma chamber 16, thereby initiating and/or maintaining the plasma 18.

For example, the chamber feed unit 14 may be an electrode or an RF antenna.

In order to minimize losses and maximize the amount of energy fed into the plasma 18, the plasma control system 10 comprises an impedance matching network 20, wherein an impedance of the impedance matching network 20 can be adapted in order to account for a varying impedance of the plasma 18.

More precisely, the impedance matching network 20 is interconnected between the RF generator module 12 and the chamber feed unit 14, such that the impedance of a load presented to the RF generator module 12 can be adapted by the impedance matching network 20.

As will be described in more detail below, the impedance of the impedance matching network 20 is controlled by a control module 22.

In general, the control module 22 controls the impedance matching network 20 based on at least one first measurement parameter obtained by a first measurement module 24, and based on at least one second measurement parameter obtained by a second measurement module 26.

Therein, the first measurement module 24 receives an input signal of the impedance matching network 20, and determines the at least one first measurement parameter based on the input signal of the impedance matching network 20.

In fact, the input signal of the impedance matching network 20 corresponds to the RF signal generated by the RF generator module 12.

The second measurement module 26 receives an output signal of the impedance matching network 20, and determines the at least one second measurement parameter based on the output signal of the impedance matching network 20.

The output signal of the impedance matching network 20 corresponds to the RF signal generated by the RF generator module 12 and processed by the impedance matching network 20.

Figure 2 schematically shows an exemplary embodiment of the impedance matching network 20 in more detail.

The impedance matching network 20 comprises an input port 28 that is connected to the RF generator module 12.

The impedance matching network 20 further comprises an output port 30 that is connected to the chamber feed unit 14.

Between the input port 28 and the output port 30, a transmission line 32 is provided that connects the input port 28 to the output port 30.

In general, the impedance matching module 20 is configured to forward the RF signal generated by the RF generator module 12 from the input port 28 to the output port 30 while matching an impedance presented to the RF generator module 12.

The impedance matching network 20 further comprises a first impedance matching module 34.

In general, the first impedance matching module 34 is configured to selectively connect at least one reactance to and/or into the transmission line 32.

The at least one reactance may comprise at least one capacitance and/or at least one inductance.

In fact, the at least one reactance may comprise a plurality of capacitances and/or a plurality of inductances.

In the exemplary embodiment shown in Figure 2, the first impedance matching module 34 is interconnected between the transmission line 32 and a common reference potential. Accordingly, the first impedance matching module 34 is configured to selectively connect at least one reactance between the transmission line and the common reference potential.

For example, the common reference potential may be a ground potential.

However, it is to be understood that the first impedance matching module 34 may alternatively be provided in the transmission line 32, wherein the first impedance matching module 34 may be interconnected between the input port 28 and the output port 30.

In this case, the first impedance matching module 34 may be configured to selectively connect the at least one reactance into the transmission line 32 between the input port 28 and the output port 30.

As is indicated in Figure 2 and as will be described in more detail below, the first impedance matching module 34 may receive a control signal from the control module 22, wherein the control signal controls the first impedance matching module 34 to adapt its impedance.

The impedance matching network 20 may comprise at least one further reactance 36, particularly at least one further inductance, that is provided in the transmission line 32.

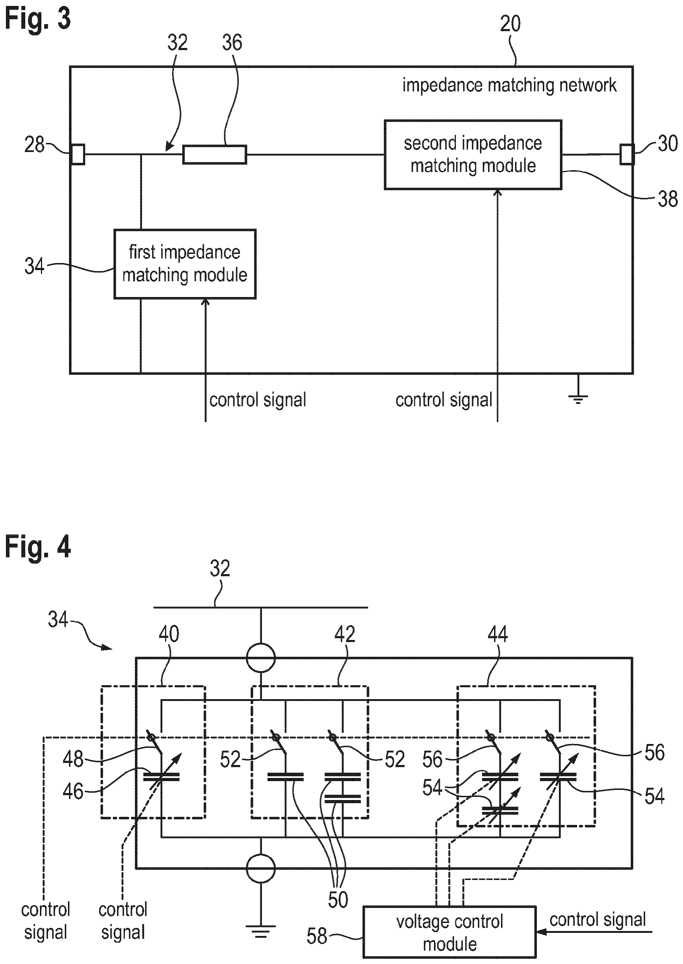

Figure 3 shows a further exemplary embodiment of the impedance matching network 20, wherein the impedance matching network 20 comprises a second impedance matching module 38.

Therein, the first impedance matching module 34 is interconnected between the transmission line 32 and the common reference potential.

The second impedance matching module 38 is provided in the transmission line 32, i.e. the second impedance matching module 38 is interconnected between the input port 28 and the output port 30.

In the exemplary embodiment shown in Figure 3, the first impedance matching module 34 is configured to selectively connect at least one reactance to the transmission line 32.

The second impedance matching module 38 is configured to selectively connect at least one reactance into the transmission line 32.

As is indicated in Figure 3 and as will be described in more detail below, the second impedance matching module 38 may receive a control signal from the control module 22, wherein the control signal controls the second impedance matching module 38 to adapt its impedance.

It is to be understood that the first impedance matching module 34 may alternatively or additionally be connected into the transmission line 32.

Alternatively or additionally, the second impedance matching module 38 may be interconnected between the transmission line 32 and the common reference potential.

Figure 4 schematically shows an exemplary embodiment of the first impedance matching module 34.

The first impedance matching module comprises a first reactance set 40, a second reactance set 42, and a third reactance set 44.

The first reactance set 40 comprises at least one adjustable reactance 46 and at least one switching circuit 48 that is assigned to the at least one adjustable reactance 46.

In general, the at least one adjustable reactance 46 has an adaptable impedance.

More precisely, the impedance of the at least one adjustable reactance 46 may be adapted based on a corresponding control signal received from the control module 22.

At least one motor being connected to the at least one adjustable reactance 46 may be provided, wherein the at least one motor is configured to adapt the impedance of the at least one adjustable reactance 46.

In the exemplary embodiment shown in Figure 4, the at least one adjustable reactance 46 is an adjustable capacitor.

In fact, the at least one adjustable reactance 46 may be a variable vacuum capacitor (VVC).

The at least one switching circuit 48 is configure to selectively connect the at least one adjustable reactance 46 to the transmission line 32 or to disconnect the at least one adjustable reactance 46 from the transmission line 32 based on a corresponding control signal received from the control module 22.

The at least one switching circuit 48 may be established as or comprise a solid-state switch. In fact, the at least one switching circuit 48 may be or comprise a mechanical switch, a micro-electromechanical systems (MEMS) switch, a semiconductor switch, a PIN diode, a MOSFET, or other suitable type of electronic circuitry.

This likewise applies to the further switching circuits described below.

The second reactance set 42 is provided in parallel to the first reactance set 40.

The second reactance set 42 comprises at least one non-adjustable reactance 50, wherein an impedance of the at least one non-adjustable reactance 50 is fixed.

In fact, the second reactance set 42 may comprise a plurality of non-adjustable reactances 50 that may be provided in series and/or in parallel.

For each parallel sub-set of reactances 50, the second reactance set 42 comprises an associated switching circuit 52, wherein the switching circuit 52 is configured to selectively connect or disconnect the respective reactances 50 to or from the transmission line 32, respectively.

More precisely, the switching circuits 52 are configured to selectively connect or disconnect the reactances 50 to or from the transmission line 32 based on a corresponding control signal received from the control module 22.

In the exemplary embodiment shown in Figure 4, the non-adjustable reactances 50 are established as a capacitor, respectively.

However, it is to be understood that, alternatively or additionally, inductors may be provided.

The third reactance set 44 is provided in parallel to the first reactance set 40 and the second reactance set 42.

The third reactance set 44 comprises at least one adjustable reactance 54.

In fact, the third reactance set 44 may comprise a plurality of adjustable reactances 54 that may be provided in series and/or in parallel.

For each parallel sub-set of reactances 54, the third reactance set 44 comprises an associated switching circuit 56, wherein the switching circuit 56 is configured to selectively connect or disconnect the respective reactances 54 to or from the transmission line 32, respectively.

More precisely, the switching circuits 56 are configured to selectively connect or disconnect the reactances 54 to or from the transmission line 32 based on a corresponding control signal received from the control module 22.

In the exemplary embodiment shown in Figure 4, the adjustable reactances 54 are established as a capacitor, respectively.

However, it is to be understood that, alternatively or additionally, inductors may be provided.

An impedance of the adjustable reactances 54 of the third reactance set can be adapted by applying a corresponding bias voltage to the respective reactances 54.

In the case of the adjustable reactances 54 being capacitors, the capacitors may comprise a reconfigurable dielectric and/or permeable material, for example barium strontium titanite (BST), wherein the capacitance of the respective capacitor changes based on the bias voltage applied, or rather based on an electric and/or magnetic field caused by the bias voltage.

In a specific example, at least one of the adjustable reactances 54 may be established as a BST varactor.

In fact, the first impedance matching module 34 comprises a voltage control module 58 that is configured to generate the corresponding bias voltages for the reactances 54 based on a control signal received from the control module 22.

More precisely, the voltage control module 58 is configured to generate the bias voltage applied to different adjustable reactances of the third reactance set 44 group-wise or individually, such that the impedances of the different adjustable reactances 54 can be adapted group-wise or for the different adjustable reactances 54 individually.

The bias voltage may be a DC voltage.

For example, the bias voltage applied to the different adjustable reactances 54 may be the same for all of the adjustable reactances 54 of the third reactance set 44.

As another example, different bias voltages may be applied to different groups of adjustable reactances 54 of the third reactance set 44.

In a further example, different bias voltages may be applied to each of the different adjustable reactances 54 of the third reactance set 44.

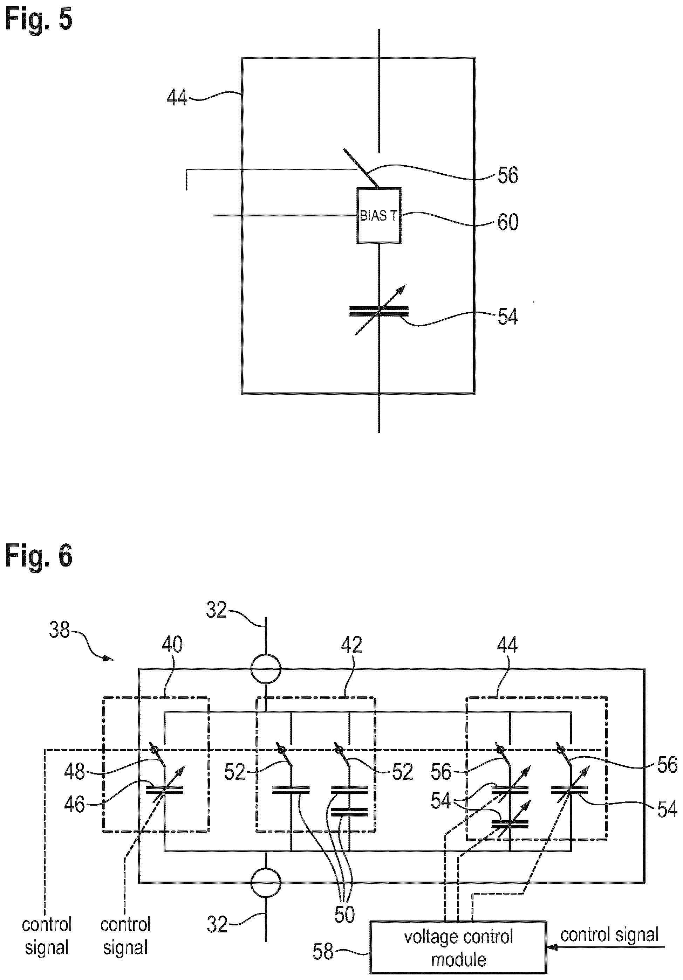

As is illustrated in Figure 5, the third reactance set 44 may comprise at least one bias tee 60 that is connected to the voltage control module 58 so as to receive the bias voltage.

The at least one bias tee 60 is connected to the at least one adjustable reactance 54 such that the bias voltage generated by the voltage control module 58 is applied to the at least one adjustable reactance 54 via the at least one bias tee 60.

In fact, the at least one bias tee 60 may be interconnected between the at least one adjustable reactance 54 and the associated switching circuit 56.

Figure 6 schematically shows the second impedance matching module 38 in more detail, wherein only the differences compared to the first impedance matching module 34 are described hereinafter.

In general, the second impedance matching module 38 may be established similarly or even identical to the first impedance matching module 34.

However, instead of being interconnected between the transmission line 32 and the common reference potential, the second impedance matching module 38 may be provided in the transmission line 32, namely between the input port 28 and the output port 30.

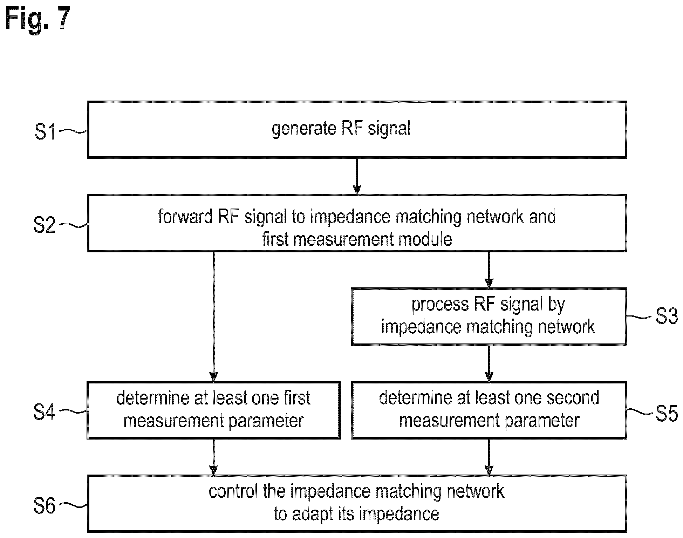

The plasma control system 10 described above is configured to perform a method of impedance matching for a plasma process that is described hereinafter with reference to Figure 7.

An RF signal is generated by the RF generator module 12 (step S1).

The RF signal is forwarded to and received by both the impedance matching network 20 and the first measurement module 24 (step S2).

Accordingly, the RF signal generated by the RF generator module 12 is an input signal of the impedance matching network 20.

Therein, the first measurement module 24 may be coupled to a signal path between the RF generator module 12 and the impedance matching network 20 upstream of the impedance matching network 20, for example by a directional coupler.

Alternatively, the first measurement module 24 may be connected to the input port 28 of the impedance matching network 20.

The RF signal generated by the RF generator module 12 is processed by the impedance matching network 20, thereby obtaining an output signal (step S3).

The output signal of the impedance matching network 20 is forwarded to both the chamber feed unit 14 and to the second measurement module 26.

Therein, the second measurement module 26 may be coupled to a signal path between the impedance matching network 20 and the chamber feed unit 14, for example by a directional coupler.

Alternatively, the second measurement module 26 may be connected to the output port 30 of the impedance matching network 20.

At least one first measurement parameter is determined by the first measurement module 24 based on the input signal of the impedance matching network 20, i.e. based on the RF signal generated by the RF generator module 12 (step S4).

The at least one first measurement parameter may comprise an amplitude of the input signal, a phase of the input signal, and/or a power level of the input signal. The amplitude and phase of the input signal may relate to a voltage of the input signal or to a current of the input signal.

Further, at least one second measurement parameter is determined by the second measurement module 26 based on the output signal of the impedance matching network 20, i.e. based on the RF signal processed by the impedance matching network 20 (step S5).

The at least one second measurement parameter may comprise an amplitude of the output signal, a phase of the output signal, and/or a power level of the output signal. The amplitude and phase of the input signal may relate to a voltage of the output signal or to a current of the output signal.

Based on the at least one first measurement parameter and based on the at least one second measurement parameter, the control module 22 controls the impedance matching network 20 to adapt its impedance (step S6).

More precisely, the control module 22 may control the first impedance matching module 34 and/or the second impedance matching module 38 to adapt their impedance according to any of the variants described above.

In fact, the control module 22 may control the first reactance set 40, the second reactance set 42, and/or the third reactance set 44 of the first impedance matching module 34 and/or of the second impedance matching module 38 to adapt their impedance, namely by adapting the respective impedance of the individual adaptable reactances, by selectively switching reactances to and/or into the transmission line 32, and/or by selectively disconnecting reactances from the transmission line 32.

Therein, the first reactance set 40, the second reactance set 42, and/or the third reactance set 44 of the first impedance matching module 34 and/or of the second impedance matching module 38 may be controlled simultaneously and/or consecutively.

The control module 22 may determine an impedance of the impedance matching network 20 based on the at least one first measurement parameter and based on the at least one second measurement parameter. The control module 22 may compare the impedance determined with a target impedance of the impedance matching network 20 that is to be set. The control module 22 may control the impedance matching network 20 to adapt its impedance based on the comparison as described above.

It is noted that, in addition to adapting the impedance of the impedance matching network, the control module 22 may also control the RF generator module to adapt a frequency of the RF signal generated. This allows to further fine-tune the transmission characteristics of the plasma control system in order to maximize the energy transferred into the plasma 18.

In fact, adapting the frequency of the RF signal generated mainly changes a reactance of the impedance matching network 20, i.e. an imaginary part of the impedance of the impedance matching network 20.

A real part of the impedance of the impedance matching network 20 may be affected by adapting the frequency of the RF signal generated, but may change substantially less than the imaginary part.

Further, it is also conceivable that the control module 22 may control the first impedance matching module 34 and/or the second impedance matching module 38 to change a matching topology, for example from an "L" topology as shown in Figure 3 to a "pi" topology, wherein both the first impedance matching module 34 and the second impedance matching module 38 may be interconnected between the transmission line 32 and the common reference potential in the "pi" topology.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. An impedance matching network for plasma processes,
wherein the impedance matching network (20) comprises an input port (28) being connectable to a radio frequency, RF, generator module (12),
wherein the impedance matching network (20) further comprises an output port (30) being connectable to a load,
wherein the impedance matching network (20) further comprises a transmission line (32), wherein the transmission line (32) connects the output port (30) to the input port (28),
wherein the impedance matching network (20) comprises a first impedance matching module (34), wherein the first impedance matching module (34) is configured to connect at least one reactance to and/or into the transmission line (32),
wherein the first impedance matching module (34) comprises a first reactance set (40) and a second reactance set (42),
wherein the first reactance set (40) of the first impedance matching module (34) comprises least one adjustable reactance (46), wherein an impedance of the at least one adjustable reactance (46) is adaptable,
wherein the second reactance set (42) of the first impedance matching module (34) comprises least one non-adjustable reactance (50), wherein an impedance of the at least one non-adjustable reactance (50) is fixed,
wherein the first reactance set (40) and the second reactance set (42) are arranged in parallel to each other, and
wherein the first impedance matching module (34) is configured to switch reactances of the first reactance set (40) and of the second reactance set (42) to and/or into the transmission line independent of each other.

2. The impedance matching network of claim 1, further comprising at least one motor being connected to the at least one adjustable reactance (46), wherein the at least one motor is configured to adapt the reactance the at least one adjustable reactance (46), particularly wherein the at least one adjustable reactance (46) is a variable vacuum capacitor, VVC.

3. The impedance matching network according to any one of the preceding claims, wherein the second reactance set (42) comprises a plurality of non-adjustable reactances (50), wherein the non-adjustable reactances (50) are arranged in parallel and/or in series.

4. The impedance matching network according to any one of the preceding claims, wherein the first impedance matching module (34) comprises a third reactance set (44), wherein the third reactance set (44) comprises at least one adjustable reactance (54), wherein an impedance of the at least one adjustable reactance (54) is adaptable by a bias voltage.

5. The impedance matching network of claim 4, wherein the third reactance set (44) comprises a plurality of adjustable reactances (54), wherein the adjustable reactances (54) are arranged in parallel and/or in series.

6. The impedance matching network of claim 4 or 5, wherein the impedance matching network (20) comprises a voltage control module (58), wherein the voltage control module (58) is connected to the at least one adjustable reactance (54) of the third reactance set (44), and wherein the voltage control module (58) is configured to control a bias voltage applied to the at least one adjustable reactance (54) of the third reactance set (44), particularly wherein the bias voltage applied is a direct current, DC, voltage.

7. The impedance matching network of claim 6, wherein the voltage control module (58) is configured to control the bias voltage applied to different adjustable reactances (54) of the third reactance set (44) group-wise or individually.

8. The impedance matching network of claim 6 or 7, wherein the impedance matching network (20) comprises at least one bias tee (60) that is connected to the at least one adjustable reactance (54) of the third reactance set (44) and to the voltage control module (58), such that the bias voltage is applied to the at least one adjustable reactance (54) via the at least one bias tee (60).

9. The impedance matching network according to any one of claims 4 to 8, wherein the third reactance set (44) is arranged in parallel to the first reactance set (40) and to the second reactance set (42), and wherein the first impedance matching module (34) is configured to switch reactances of the first reactance set (40), of the second reactance set (42), and of the third reactance set (44) to and/or into the transmission line (32) independent of each other.

10. The impedance matching network according to any one of the preceding claims, further comprising a second impedance matching module (38), wherein the first impedance matching module (34) is connected between the transmission line (32) and a common reference potential, and wherein the second impedance matching module (38) is arranged in the transmission line (32) between the input port (28) and the output port (30).

11. The impedance matching network of claim 10, wherein the second impedance matching module (38) comprises a first reactance set (40) and a second reactance set (42),
wherein the first reactance set (40) of the second impedance matching module (38) comprises least one adjustable reactance (46), wherein an impedance of the at least one adjustable reactance (46) is adaptable,
wherein the second reactance set (42) of the second impedance matching module (38) comprises least one non-adjustable reactance (50), wherein an impedance of the at least one non-adjustable reactance (50) is fixed,
wherein the first reactance set (40) and the second reactance set (42) are arranged in parallel to each other, and
wherein the second impedance matching module (38) is configured to switch reactances of the first reactance set (40) and of the second reactance set (42) to and/or into the transmission line (32) independent of each other.

12. A plasma control system, wherein the plasma control system (10) comprises at least one impedance matching network (20) according to any one of the preceding claims.

13. The plasma control system of claim 12, wherein the plasma control system (10) further comprises at least one RF generator module (12), and at least one chamber feed unit (14), wherein the at least one chamber feed unit (14) is configured to feed energy into plasma (18), wherein the input port (28) of the at least one impedance matching network (20) is connected to the at least one RF generator module (12), and wherein the output port (30) of the at least one impedance matching network (20) is connected to the at least one chamber feed unit (14).

14. The plasma control system of claim 12 or 13, wherein the plasma control system (10) further comprises a first measurement module (24), a second measurement module (26), and a control module (22),
wherein the first measurement module (24) is connected to the at least one RF generator module (12), wherein the first measurement module (24) is configured to determine at least one first measurement parameter based on at least one RF signal generated by the at least one RF generator module (12),
wherein the second measurement module (26) is connected to the output port (30) of the at least one impedance matching network (20), wherein the second measurement module (26) is configured to determine at least one second measurement parameter based on at least one output signal of the at least one impedance matching network (20), and
wherein the control module (22) is configured to control the at least one impedance matching network (20) based on the at least one first measurement parameter and based on the at least one second measurement parameter.

15. A method of impedance matching for a plasma process, the method comprising the steps of
- generating, by at least one RF generator module (12), at least one RF signal;
- processing, by at least one impedance matching network (20), particularly by at least one impedance matching network (20) according to any one of claims 1 to 11, the at least one RF signal, thereby obtaining at least one output signal;
- feeding the at least one output signal to at least one chamber feed unit (14);
- determining, by a first measurement module (24), at least one first measurement parameter based on the at least one RF signal;
- determining, by a second measurement module (26), at least one second measurement parameter based on the at least one output signal; and
- controlling, by a control module (22), the at least one impedance matching network (20) to adapt an impedance of the at least one impedance matching network (20) based on the at least one first measurement parameter and based on the at least one second measurement parameter.
